(19) Europäisches Patentamt
European Patent Office
Office européen des brevets

(11) EP 4 676 196 A1

(12) # EUROPEAN PATENT APPLICATION
published in accordance with Art. 153(4) EPC

(43) Date of publication:
**07.01.2026 Bulletin 2026/02**

(21) Application number: **24818438.4**

(22) Date of filing: **10.05.2024**

(51) International Patent Classification (IPC):
***H10K 30/20** (2023.01)* ***H10K 71/12** (2023.01)*
***H10K 71/15** (2023.01)* ***H10K 71/40** (2023.01)*

(52) Cooperative Patent Classification (CPC):
Y02E 10/549

(86) International application number:
**PCT/CN2024/092392**

(87) International publication number:
**WO 2024/250905 (12.12.2024 Gazette 2024/50)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.06.2023 CN 202310664529**
**07.05.2024 CN 202410557843**

(71) Applicant: **Contemporary Amperex Technology Co., Limited**
**Ningde, Fujian 352100 (CN)**

(72) Inventors:
- **XIANG, Ling**
  **Ningde, Fujian 352100 (CN)**
- **LIANG, Weifeng**
  **Ningde, Fujian 352100 (CN)**
- **CHEN, Changsong**
  **Ningde, Fujian 352100 (CN)**
- **TU, Bao**
  **Ningde, Fujian 352100 (CN)**
- **MA, Junfu**
  **Ningde, Fujian 352100 (CN)**
- **GUO, Yongsheng**
  **Ningde, Fujian 352100 (CN)**

(74) Representative: **Kraus & Lederer PartGmbB**
**Thomas-Wimmer-Ring 15**
**80539 München (DE)**

(54) **PEROVSKITE SOLAR CELL, MANUFACTURING METHOD THEREFOR AND PHOTOVOLTAIC MODULE**

(57) The present application provides a perovskite solar cell, a preparation method therefor, and a photovoltaic module. The perovskite solar cell includes a perovskite light absorption layer. The perovskite light absorption layer includes a perovskite material and a complexing agent. The complexing agent includes one or more of a hydroxycarboxylic acid-based complexing agent, an organic phosphonic acid-based complexing agent, a polyacrylic acid-based complexing agent, and a polybutenoic acid-based complexing agent. The perovskite solar cell, the preparation method therefor, and the photovoltaic module according to the present application reduce ion migration in perovskite while passivating defects, to reduce the degradation of the perovskite light absorption layer and the failure of functional layers, thus improving the device efficiency and stability.

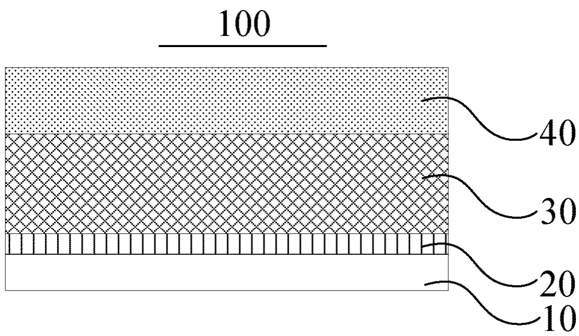


FIG. 1

EP 4 676 196 A1

## Description

### CROSS-REFERENCE TO RELATED APPLICATIONS

The present application claims priority to Chinese Patent Application No. 2023106645292, filed on June 06, 2023, which is incorporated herein by reference in its entirety.

### TECHNICAL FIELD

The present invention relates to the technical field of new energy, and in particular, to a perovskite solar cell, a preparation method therefor, and a photovoltaic module.

### BACKGROUND

This section only provides background information related to the present application, which is not necessarily the prior art.

At present, the efficiency of perovskite solar cells has reached 25.6%, which is close to that of the silicon-based solar cells that have been mature for many years, so improving the device stability is the key to realize the commercialization of perovskite solar cells. Many defects and ion migration in perovskite will lead to the degradation of a perovskite light absorption layer and the failure of functional layers.

### SUMMARY

The technical problem to be mainly solved by the present application is that various defects and ion migration in perovskite may lead to the degradation of a perovskite light absorption layer.

In order to solve the above technical problems, a technical solution used in the present application is: a perovskite solar cell, including a perovskite light absorption layer. The perovskite light absorption layer includes a perovskite material and a complexing agent. The complexing agent includes one or more of a hydroxycarboxylic acid-based complexing agent, an organic phosphonic acid-based complexing agent, a polyacrylic acid-based complexing agent, and a polybutenoic acid-based complexing agent.

In one or more embodiments of the present application, provided is a perovskite solar cell. By the introduction of a complexing agent, the defect state density in the device is reduced, and perovskite passivation is achieved. The complexing agent undergoes a complexing reaction with metal ions in the perovskite material by means of its relatively strong complexing ability to form a stable complex, which is beneficial to reducing the migration of metal ions. The corresponding perovskite solar cell reduces ion migration in perovskite while passivating defects, which is beneficial to reducing the degradation of the perovskite light absorption layer and the failure of functional layers, thus improving the device efficiency and stability.

In some embodiments, the hydroxycarboxylic acid-based complexing agent includes one or more of a carboxylic acid with a structural formula of

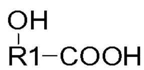

and a carboxylate with a structural formula of

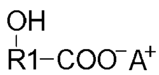
,

where R1 is any one of a linear hydrocarbon group, a linear hydrocarbon group containing a heteroatom, aryl, heteroaryl, a cyclic hydrocarbon group, and a cyclic hydrocarbon group containing a heteroatom; the heteroatom includes an oxygen atom; and $A^+$ includes any one of $Na^+$, $K^+$, and $NH_4^+$.

In one or more embodiments of the present application, the provided hydroxycarboxylic acid-based complexing agent undergoes a complexing reaction with metal cations in the perovskite material, thus reducing the defect density and ion migration in the perovskite material.

In some embodiments, the group R1 includes at least one functional group, and the functional group includes one or two of hydroxyl and carboxyl.

In one or more embodiments of the present application, the hydroxycarboxylic acid-based complexing agent

undergoes a complexing reaction with the metal cations in the perovskite material by means of a plurality of hydroxyl groups and a plurality of carboxyl groups, thus reducing the defect density and ion migration in the perovskite material.

In some embodiments, the hydroxycarboxylic acid-based complexing agent includes one or more of tartaric acid, heptonic acid, gluconic acid, and alginic acid; and/or the hydroxycarboxylic acid-based complexing agent includes one or more of a sodium salt, a potassium salt, and an ammonium salt of tartaric acid, heptonic acid, gluconic acid, and alginic acid.

In one or more embodiments of the present application, the hydroxycarboxylic acid-based complexing agent undergoes a complexing reaction with metal cations in the perovskite material by means of a plurality of hydroxyl functional groups and carboxyl functional groups contained therein, thus reducing the migration of metal ions.

In some embodiments, the organic phosphonic acid-based complexing agent includes one or more of an organic phosphonic acid with a structural formula of

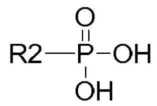

and an organic phosphonate with a structural formula of

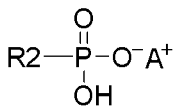

,

where R2 is any one of a linear hydrocarbon group and a linear hydrocarbon group containing a heteroatom; the heteroatom includes one or more of a nitrogen atom, a phosphorus atom, and an oxygen atom; and $A^+$ includes any one of $Na^+$, $K^+$, and $NH_4^+$.

In one or more embodiments of the present application, the provided organic phosphonic acid-based complexing agent undergoes a complexing reaction with metal cations in the perovskite material, reducing the defect density and ion migration in the perovskite material.

In some embodiments, R2 includes at least one functional group, and the functional group includes one or more of a phosphonic acid group, hydroxyl, a carbon-carbon double bond, and amino.

In one or more embodiments of the present application, the organic phosphonic acid-based complexing agent undergoes a complexing reaction with the metal cations in the perovskite material by means of one or more of a phosphonic acid group, hydroxyl, and amino, thus reducing the defect density and ion migration in the perovskite material, and the introduction of a carbon-carbon double bond is beneficial to the formation of a conjugated system, thereby reducing the energy of the system and improving the stability of the system.

In some embodiments, the organic phosphonic acid-based complexing agent includes one or more of ethylenediamine tetramethylene phosphonic acid, hydroxyethylidene diphosphonic acid, diethylenetriamine pentamethylene phosphonic acid, and aminotrimethylene phosphonic acid; and/or the organic phosphonic acid-based complexing agent includes one or more of a sodium salt, a potassium salt, and an ammonium salt of ethylenediamine tetramethylene phosphonic acid, hydroxyethylidene diphosphonic acid, diethylenetriamine pentamethylene phosphonic acid, and aminotrimethylene phosphonic acid.

In one or more embodiments of the present application, the organic phosphonic acid-based complexing agent undergoes a complexing reaction with the metal cations in the perovskite material by means of a plurality of phosphonic acid groups contained therein, thus reducing the migration of metal ions. In addition, the coordination atoms N and P contained in the organic phosphonic acid-based complexing agent easily form hydrogen bonds with the defect states in the perovskite, which is beneficial to reducing the defect density in the device and improving the efficiency of the device.

In some embodiments, the polyacrylic acid-based complexing agent includes one or more of polyacrylic acid, polyhydroxyacrylic acid, and polyacrylamide; and/or the polybutenoic acid-based complexing agent includes one or more of polymaleic anhydride and a maleic acid-acrylic acid copolymer.

In one or more embodiments of the present application, the polyacrylic acid-based complexing agent and/or the polybutenoic acid-based complexing agent undergo a complexing reaction with the metal cations in the perovskite material by means of a plurality of carboxylic acid groups and a plurality of hydroxyl groups contained therein, thus reducing the metal ion migration ability.

In some embodiments, the perovskite light absorption layer includes a perovskite composite layer, and the perovskite composite layer includes the perovskite material and the complexing agent.

In one or more embodiments of the present application, the perovskite material and the complexing agent work together to form a perovskite composite layer, so that the complexing agent acts as a bulk passivator to passivate various

defects that may occur in the perovskite composite layer during the formation of the perovskite composite layer and reduce the migration of metal ions in the perovskite material, thereby improving the device efficiency and stability of the perovskite solar cell.

In some embodiments, the perovskite light absorption layer includes a perovskite layer and a complexing layer arranged on one side of the perovskite layer, the perovskite layer includes the perovskite material, and the complexing layer includes the complexing agent.

In the embodiments of the present application, the complexing agent is used to modify at least one surface of the perovskite layer to passivate interface defects in the perovskite layer and reduce the migration of metal ions in the perovskite material to the adjacent carrier transport layer.

In some embodiments, the perovskite light absorption layer includes a perovskite composite layer and a complexing layer. The complexing agent includes a first complexing agent and a second complexing agent. The perovskite composite layer includes the perovskite material and the first complexing agent, and the complexing layer includes the second complexing agent. The first complexing agent and the second complexing agent are the same or different.

In one or more embodiments of the present application, by means of the perovskite composite layer, the first complexing agent acts as a bulk passivator to passivate various defects that may occur in the perovskite composite layer and reduce the migration of metal ions in the perovskite material. The second complexing agent acts as an interface passivator to passivate interface defects in the perovskite composite layer and reduce the migration of metal ions in the perovskite material to the adjacent carrier transport layer. By means of the combined action of the first complexing agent and the second complexing agent, the defects in the perovskite light absorption layer are further passivated, to further passivate defects in the perovskite light absorption layer and reduce the migration of metal ions in the perovskite material, thereby improving the device efficiency and stability of the perovskite solar cell.

In some embodiments, the thickness of the perovskite layer or the perovskite composite layer is 300 nm-700 nm.

In one or more embodiments of the present application, by providing some specific thicknesses of the perovskite layer or the perovskite composite layer, the perovskite solar cell in which the perovskite layer or the perovskite composite layer falls within the thickness range has a good device performance.

In some embodiments, the thickness of the complexing layer is 10 nm-80 nm.

In one or more embodiments of the present application, by providing some specific thicknesses of the complexing layer, on the one hand, the complexing layer within this thickness range has a good passivation effect and a good ability to reduce the migration of metal ions in the perovskite layer or the perovskite composite layer; on the other hand, the complexing layer results in a relatively small interface resistance, resulting in a relatively small impact on charge transport between the perovskite layer or the perovskite composite layer and the adjacent carrier transport layer.

In some embodiments, the perovskite solar cell includes a substrate, a first electrode layer, a perovskite light absorption layer, and a second electrode layer, which are stacked in order.

In one or more embodiments of the present application, by providing some specific structures of the perovskite solar cell, the first electrode layer and the second electrode layer can form a current loop in external manner to drive a load or store electricity.

In some embodiments, the perovskite solar cell further includes a carrier transport layer. The carrier transport layer is arranged between the first electrode layer and the perovskite light absorption layer and/or arranged between the second electrode layer and the perovskite light absorption layer.

In one or more embodiments of the present application, the carrier transport layer arranged in the perovskite solar cell helps to transport electron-hole pairs excited by photons in the perovskite light absorption layer to the electrode layers, so that non-radiative recombination of electron-hole pairs in the perovskite light absorption layer are reduced while defects are passivated, thus improving the device efficiency.

In a second aspect, an embodiment of the present application provides a method for preparing a perovskite solar cell, including:

providing an intermediate member including a substrate and a first electrode layer;
forming a perovskite light absorption layer precursor on the first electrode layer, where during the formation of the perovskite light absorption layer precursor, a complexing agent is added, and the complexing agent includes one or more of a hydroxycarboxylic acid-based complexing agent, an organic phosphonic acid-based complexing agent, a polyacrylic acid-based complexing agent, and a polybutenoic acid-based complexing agent; and
annealing the perovskite light absorption layer precursor to obtain a perovskite light absorption layer.

In one or more embodiments of the present application, a method for preparing a perovskite solar cell is provided, such that during the formation of the perovskite light absorption layer, the complexing agent passivates various defects that may occur in the perovskite light absorption layer and reduces the migration of metal ions in the perovskite.

In some embodiments, a first carrier transport layer is arranged between the first electrode layer and the perovskite light absorption layer, and the method for preparing the perovskite solar cell includes:

providing an intermediate member including a substrate, a first electrode layer, and a first carrier transport layer;
forming a perovskite light absorption layer precursor on the first carrier transport layer, where during the formation of the perovskite light absorption layer precursor, a complexing agent is added, and the complexing agent includes one or more of a hydroxycarboxylic acid-based complexing agent, an organic phosphonic acid-based complexing agent, a polyacrylic acid-based complexing agent, and a polybutenoic acid-based complexing agent; and
annealing the perovskite light absorption layer precursor to obtain a perovskite light absorption layer.

In one or more embodiments of the present application, a method for preparing a perovskite solar cell is provided, such that during the formation of the perovskite light absorption layer, the complexing agent passivates various defects that may occur in the perovskite light absorption layer and reduces the migration of metal ions in the perovskite.
In some embodiments, the formation of the perovskite light absorption layer precursor on the first carrier transport layer includes:
applying a perovskite precursor solution containing a complexing agent to the first carrier transport layer to form a perovskite composite layer.
In one or more embodiments of the present application, the perovskite material and the complexing agent work together to form a perovskite light absorption layer, so that various defects that may occur in the perovskite material are passivated, and the migration of metal ions in the perovskite is reduced.
In some embodiments, the formation of the perovskite light absorption layer precursor on the first carrier transport layer includes:
applying a perovskite precursor solution containing a complexing agent to the first carrier transport layer, where the concentration of the complexing agent in the perovskite precursor solution containing the complexing agent is less than or equal to 10% of the concentration of a cation in position B in the perovskite precursor.
In one or more embodiments of the present application, the addition amount of the complexing agent in the perovskite precursor solution is adjusted to passivate various defects that may occur in the perovskite material and reduce the migration of metal ions in the perovskite.
In some embodiments, the formation of the perovskite light absorption layer precursor on the first carrier transport layer includes:

forming a perovskite layer on the first carrier transport layer; and
applying a complexing agent solution to a surface of the perovskite layer away from the first carrier transport layer.

In one or more embodiments of the present application, by means of the provided method for forming the complexing layer on the perovskite layer, possible interface defects between the perovskite layer and the adjacent carrier transport layer are passivated, and the migration of metal ions in the perovskite material to the adjacent carrier transport layer is reduced, thus improving the device efficiency and stability of the perovskite solar cell.
In some embodiments, the concentration of the complexing agent solution is greater than 0 and less than or equal to 20 mg/ml.
In one or more embodiments of the present application, the concentration of the complexing agent solution is greater than 0 and less than or equal to 20 mg/ml, which results in a good ability to passivate interface defects and hinder ion migration.
In some embodiments, the formation of the perovskite light absorption layer precursor on the first carrier transport layer includes:

applying a perovskite precursor solution containing a complexing agent to the first carrier transport layer to form a perovskite composite layer, where the concentration of the complexing agent in the perovskite precursor solution containing the complexing agent is less than or equal to 10% of the concentration of a cation in position B in the perovskite precursor; and
applying a complexing agent solution to a surface of the perovskite composite layer away from the first carrier transport layer.

In one or more embodiments of the present application, by means of the provided complexing agent participating in the formation of the perovskite composite layer and the formation of the complexing layer on the surface of the perovskite composite layer, not only can reduced defects in the bulk phase of the perovskite material and reduced migration of metal ions in the perovskite material be achieved, but also interface defects in the perovskite composite layer can be reduced and the migration of ions in the perovskite material to the adjacent carrier transport layer can be further reduced, thereby improving the photoelectric conversion effect and/or stability of the corresponding perovskite solar cell.
In a third aspect, an embodiment of the present application provides a photovoltaic module, including any perovskite solar cell provided in the first aspect or a perovskite solar cell prepared by any method for preparing a perovskite

solar cell as provided in the second aspect.

In a fourth aspect, an embodiment of the present application provides a power generation apparatus including the photovoltaic module provided in the third aspect. The power generation apparatus in which the photovoltaic module provided by the present application is used has at least the same advantages as the photovoltaic module, so that the power consumption performance of the power generation apparatus can be improved.

In a fifth aspect, an embodiment of the present application provides an electrical device including the photovoltaic module provided in the third aspect. The electrical device in which the solar cell provided by the present application is used has at least the same advantages as the solar cell, so that the cell performance of the electrical device can be improved.

## BRIEF DESCRIPTION OF THE DRAWINGS

In order to more clearly explain the technical solution in the embodiments of the present application, the accompanying drawings required for the description of the embodiments will be briefly introduced below. Apparently, the accompanying drawings in the following description are only some embodiments of the present application, and other accompanying drawings can also be obtained according to these accompanying drawings without involving creative effort.

FIG. 1 is a schematic view of a first structure of a perovskite solar cell provided by an embodiment of the present application;
FIG. 2 is a schematic view of a second structure of a perovskite solar cell provided by an embodiment of the present application;
FIG. 3 is a schematic view of a third structure of a perovskite solar cell provided by an embodiment of the present application;
FIG. 4 is a schematic view of a fourth structure of a perovskite solar cell provided by an embodiment of the present application;
FIG. 5 is a schematic structural view of a photovoltaic module provided by an embodiment of the present application;
FIG. 6 is a schematic structural view of a power generation apparatus provided by an embodiment of the present application; and
FIG. 7 is a schematic structural view of an electrical device provided by an embodiment of the present application.

In the drawings, the drawings are not drawn to actual scale.

Explanation of reference numerals:

1000 - photovoltaic module, 2000 - power generation apparatus, 3000 - electrical device, 100 - perovskite solar cell, 200 - cell string, 300 - front glass, 400 - front encapsulation film, 500 - back encapsulation film, 600 - back glass, 10 - substrate, 20 - first electrode layer, 30 - perovskite light absorption layer, 40 - second electrode layer, 50 - carrier transport layer, 51 - first carrier transport layer, 52 - second carrier transport layer, 31 - perovskite layer, 32 - complexing layer, and 33 - perovskite composite layer.

## DETAILED DESCRIPTION

The technical solution in the embodiments of the present application will be described below clearly and completely with reference to the accompanying drawings in the embodiments of the present application. Apparently, the described embodiments are only some, rather than all, of the embodiments of the present application. Based on the embodiments of the present application, all other embodiments obtained without involving any creative effort fall within the scope of protection of the present application.

The terms "first", "second", and "third" in the present application are only used for descriptive purposes and cannot be understood as indicating or implying relative importance or implicitly indicating the number of indicated technical features. Therefore, the features defined using "first", "second", and "third" can explicitly or implicitly include at least one of the feature. In the description of the present application, "a plurality of" means at least two, such as two and three, unless otherwise explicitly and specifically defined. All directional indications (such as up, down, left, right, front, and back) in the embodiments of the present application are only used to explain the relative position relationship, movement, etc. between the components in a certain posture (as shown in the figures). If the certain posture changes, the directional indications will also change accordingly. Furthermore, that terms "include" and "have" and any variations thereof are intended to cover non-exclusive inclusion. For example, processes, methods, systems, products, or devices that include a series of steps or units are not limited by the listed steps or units, but optionally further include steps or units that are not listed, or optionally further include other steps or units that are inherent to these processes, methods, products, or devices.

Reference to "embodiment" herein means that a particular feature, structure or characteristic described in connection with an embodiment can be included in at least one embodiment of the present application. The appearance of this phrase in various places in the specification does not necessarily refer to the same embodiment, nor is it an independent or alternative embodiment mutually exclusive with other embodiments. It is explicitly and implicitly understood that the embodiments described herein can be combined with other embodiments.

In order to improve the film layer quality of the perovskite layer and reduce various defects and ion migration in perovskite, researchers have used various means to perform material improvement and/or interface modification on the perovskite layer. In some solutions, an anti-solvent method is used to adjust and control the crystal growth of perovskite to improve the quality of the perovskite film layer; however, in this method, an excessively fast crystallization rate easily occurs, which leads to uncontrollable crystal morphology of perovskite, thus affecting the photoelectric conversion performance of the perovskite layer. In some other solutions, a method for adjusting and controlling the crystallization rate of perovskite by adding auxiliaries to an anti-solvent is involved. However, this method further results in the influence of the auxiliaries on the crystallization of perovskite, which easily leads to uncontrollable crystallographic morphology, thus limiting the device efficiency and stability.

An embodiment of the present application provides a perovskite solar cell, including a perovskite light absorption layer. The perovskite light absorption layer includes a perovskite material and a complexing agent. The complexing agent includes one or more of a hydroxycarboxylic acid-based complexing agent, an organic phosphonic acid-based complexing agent, a polyacrylic acid-based complexing agent, and a polybutenoic acid-based complexing agent.

The complexing agent has a relatively strong complexing ability and can form a stable complex with metal ions to inhibit the migration of metal ions. In addition, the coordination atoms in the complexing agent can form a hydrogen bond with a cation in position A of perovskite to inhibit the migration of the cation in position A. Therefore, the introduction of the complexing agent can inhibit ion migration in the perovskite solar cell device while passivating defects, thus achieving a high efficiency and a long-term stability of the device.

The technical solution described in the embodiment of the present application is suitable for a perovskite solar cell and a preparation method therefor and for a perovskite solar cell. The perovskite solar cell disclosed by the present application, which can be used for forming a stack layer, can also be used for forming a silicon-perovskite stack cell.

The present application will be described below in detail with reference to the accompanying drawings and embodiments.

An embodiment of the present application provides a perovskite solar cell, including a perovskite light absorption layer. The perovskite light absorption layer includes a perovskite material and a complexing agent. The complexing agent includes one or more of a hydroxycarboxylic acid-based complexing agent, an organic phosphonic acid-based complexing agent, a polyacrylic acid-based complexing agent, and a polybutenoic acid-based complexing agent.

In an embodiment of the present application, the perovskite solar cell is a solar cell in which a perovskite semiconductor is used as light-absorbing material and belongs to the third generation solar cells. The perovskite light absorption layer represents a core component of the perovskite solar cell and is used for absorbing photon energy of sunlight to generate electron-hole pairs, and the electron-hole pairs are separated into free electrons and holes under the action of a built-in electric field. The holes are collected by the first electrode layer via the hole transport layer, and the electrons are collected by the second electrode layer via the electron transport layer. The first electrode layer and the second electrode layer are connected to form a circuit to generate a photocurrent. The perovskite material refers to a material with the same crystal form structure as $CaTiO_3$, presents a cubic crystal phase in a stable state, and is used as the main forming material of the perovskite light absorption layer. In some embodiments, the perovskite material includes $ABX_3$ or $A_2CDX_6$, where A includes one or more of methylamine cation $MA^+$, formamidine cation $FA^+$, cesium cation $Cs^+$, and rubidium cation $Rb^+$; B includes one or two of lead cation $Pb^{2+}$ and tin cation $Sn^{2+}$; C includes silver cation $Ag^+$; D includes one or more of bismuth cation $Bi^{3+}$, antimony cation $Sb^{3+}$, and indium cation $In^{3+}$; and X includes one or more of chlorine anion $Cl^-$, bromine anion $Br^-$, or iodine anion $I^-$.

The complexing agent has a relatively strong complexing ability and can form a stable complex with metal ions in perovskite to reduce the migration of metal ions, passivate defects in perovskite, and improve the device efficiency and stability. The hydroxycarboxylic acid-based complexing agent contains a plurality of hydroxyl groups and carboxyl groups, the organic phosphonic acid-based complexing agent contains a plurality of phosphonic acid groups, the polyacrylic acid-based complexing agent contains a plurality of carboxyl groups, and the polybutenoic acid-based complexing agent contains a plurality of carboxyl groups, which can undergo a chelation reaction with metal cations in the perovskite material to reduce the migration of metal ions and passivate defects in perovskite.

In one or more embodiments of the present application, provided is a perovskite solar cell. By the introduction of a complexing agent, the defect state density in the device is reduced, and the passivation of the perovskite material is achieved. The complexing agent undergoes a complexing reaction with metal ions in the perovskite material by means of its relatively strong complexing ability to form a stable complex, reducing the migration of metal ions. The corresponding perovskite solar cell reduces ion migration in the perovskite material while passivating defects, which is beneficial to reducing the degradation of the perovskite light absorption layer and the failure of functional layers, thus improving the

device efficiency and stability.

In some embodiments, the complexing agent includes a hydroxycarboxylic acid-based complexing agent, and the hydroxycarboxylic acid-based complexing agent includes one or more of a carboxylic acid with a structural formula of

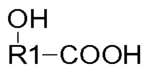

and a carboxylate with a structural formula of

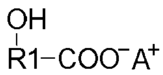,

where R1 is any one of a linear hydrocarbon group, a linear hydrocarbon group containing a heteroatom, aryl, heteroaryl, a cyclic hydrocarbon group, and a cyclic hydrocarbon group containing a heteroatom; the heteroatom includes an oxygen atom; and $A^+$ includes any one of $Na^+$, $K^+$, and $NH_4^+$.

In the embodiments of the present application, the linear hydrocarbon group refers to one or more of open-chain hydrocarbon groups, including alkyl, alkenyl, and alkynyl. A linear hydrocarbon group containing a heteroatom refers to a group formed by replacing some elements in the carbon chain of a linear hydrocarbon group with non-carbon elements. Aryl refers to a group formed by removing a hydrogen atom from an unsaturated carbocyclic compound with special stability, with the atoms constituting the ring system being carbon atoms. Heteroaryl refers to a group formed by replacing some carbon elements in the cyclic structure of aryl by non-carbon elements. A cyclic hydrocarbon group refers to a group formed by removing a hydrogen atom from a saturated carbocyclic compound. A cyclic hydrocarbon group containing a heteroatom refers to a group formed by replacing some carbon elements in the cyclic structure of a cyclic hydrocarbon group with non-carbon elements.

The hydroxycarboxylic acid-based complexing agent contains hydroxyl directly connected to a carbon atom and also carboxyl directly connected to a carbon atom, for enabling a complexing reaction with the metal cations in the perovskite material and reducing the defect density in the perovskite material.

In one or more embodiments of the present application, the provided hydroxycarboxylic acid-based complexing agent undergoes a complexing reaction with metal cations in the perovskite material, thus reducing the defect density and ion migration in the perovskite material.

In some embodiments, the group R1 includes at least one functional group, and the functional group includes one or two of hydroxyl and carboxyl.

The group R1 may include a plurality of functional groups, and the plurality of functional groups may all be hydroxyl or carboxyl, or partially be hydroxyl or partially be carboxyl.

In one or more embodiments of the present application, the hydroxycarboxylic acid-based complexing agent undergoes a complexing reaction with the metal cations in the perovskite material by means of a plurality of hydroxyl groups and carboxyl groups, thus reducing the defect density and ion migration in the perovskite material.

In some embodiments, the hydroxycarboxylic acid-based complexing agent includes one or more of tartaric acid, heptonic acid, gluconic acid, and alginic acid; and/or the hydroxycarboxylic acid-based complexing agent includes one or more of a sodium salt, a potassium salt, and an ammonium salt of tartaric acid, heptonic acid, gluconic acid, and alginic acid.

In the embodiments of the present application, the molecular structural formula of tartaric acid is:

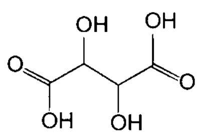.

The molecular structural formula of heptonic acid is:

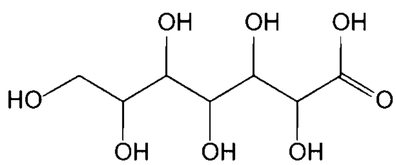.

The molecular structural formula of gluconic acid is:

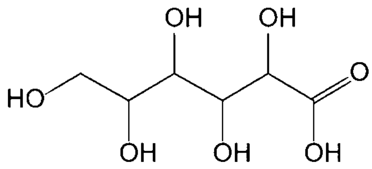.

The chemical formula of alginic acid is: $(C_6H_8O_6)n$, where the value of n is in a range of 1-20.

In one or more embodiments of the present application, the hydroxycarboxylic acid-based complexing agent undergoes a complexing reaction with metal cations in the perovskite material by means of a plurality of hydroxyl functional groups and carboxyl functional groups contained therein, thus reducing the migration of metal ions.

In some embodiments, the organic phosphonic acid-based complexing agent includes one or more of an organic phosphonic acid with a structural formula of

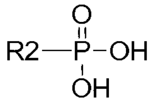

and an organic phosphonate with a structural formula of

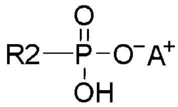,

where R2 is any one of a linear hydrocarbon group and a linear hydrocarbon group containing a heteroatom; the heteroatom includes one or more of a nitrogen atom, a phosphorus atom, and an oxygen atom; and $A^+$ includes any one of $Na^+$, $K^+$, and $NH_4^+$.

In one or more embodiments of the present application, the provided organic phosphonic acid-based complexing agent undergoes a complexing reaction with metal cations in the perovskite material, reducing the defect density and ion migration in the perovskite material.

In some embodiments, R2 includes at least one functional group, and the functional group includes one or more of a phosphonic acid group, hydroxyl, a carbon-carbon double bond, and amino.

The chemical formula of the phosphonic acid group is $-PO_3H_2$. R2 may include a plurality of functional groups, and the plurality of functional groups may all be the same group, or may also be at least two of a phosphonic acid group, hydroxyl, a carbon-carbon double bond, and amino group.

In one or more embodiments of the present application, the organic phosphonic acid-based complexing agent undergoes a complexing reaction with the metal cations in the perovskite material by means of one or more of a phosphonic acid group, hydroxyl, and amino, thus reducing the defect density and ion migration in the perovskite material, and the introduction of a carbon-carbon double bond is beneficial to the formation of a conjugated system, thereby reducing the energy of the system and improving the stability of the system.

In some embodiments, the complexing agent includes an organic phosphonic acid-based complexing agent, and the organic phosphonic acid-based complexing agent includes one or two of an organic phosphonic acid and a salt of an organic phosphonic acid. The organic phosphonic acid-based complexing agent includes a phosphonic acid group directly connected to a carbon atom. The organic phosphonic acid includes one or more of ethylenediamine tetramethylene phosphonic acid, hydroxyethylidene diphosphonic acid, diethylenetriamine pentamethylene phosphonic acid, and aminotrimethylene phosphonic acid. The salt of the organic phosphonic acid includes one or more of a sodium salt, a potassium salt, and an ammonium salt.

In the embodiments of the present application, the molecular structural formula of the ethylenediamine tetramethylene phosphonic acid is

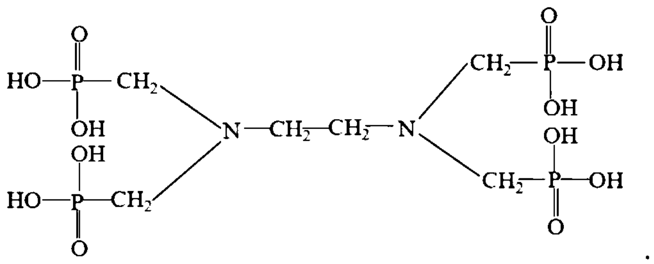

The molecular structural formula of the hydroxyethylidene diphosphonic acid is

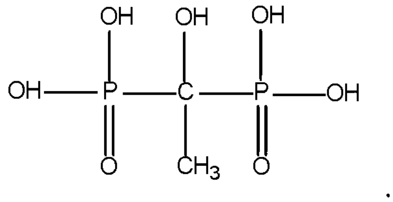

The molecular structural formula of the diethylenetriamine pentamethylene phosphonic acid is

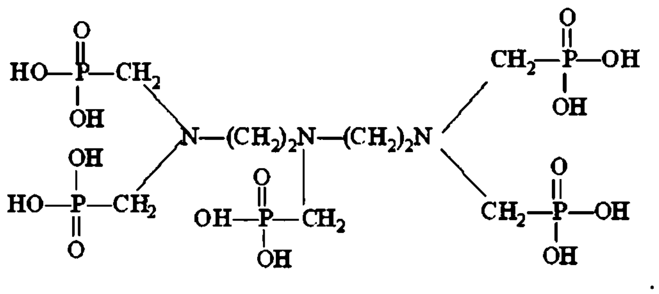

The molecular structural formula of the aminotrimethylene phosphonic acid is

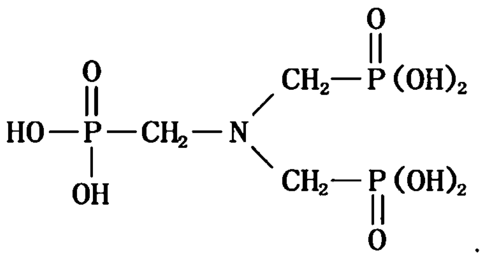

In one or more embodiments of the present application, the organic phosphonic acid-based complexing agent undergoes a complexing reaction with the metal cations in the perovskite material by means of a plurality of phosphonic acid groups contained therein, thus reducing the migration of metal ions. In addition, the coordination atoms N and P contained in the organic phosphonic acid-based complexing agent easily form hydrogen bonds with defects in the perovskite material, which is beneficial to reducing the defect density in the device and improving the device efficiency.

In some embodiments, the polyacrylic acid-based complexing agent includes one or more of polyacrylic acid, polyhydroxyacrylic acid, and polyacrylamide; and/or the polybutenoic acid-based complexing agent includes one or more of polymaleic anhydride and a maleic acid-acrylic acid copolymer.

In the embodiments of the present application, the molecular structural formula of the polyacrylic acid is

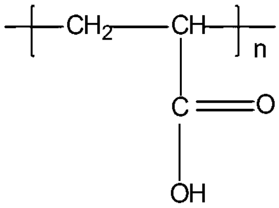

,

where the value of n is in a range of 3000-9000. The molecular structural formula of the polyhydroxyacrylic acid is

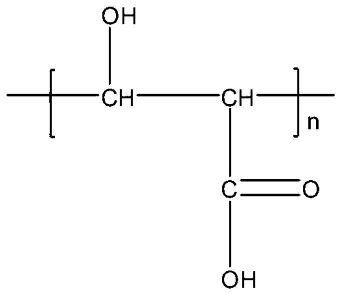

,

where the value of n is in a range of 3000-9000. The molecular structural formula of the polyacrylamide is

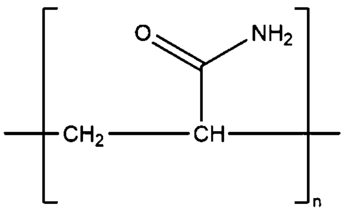

,

where the value of n is in a range of 300-900. The molecular structural formula of the polymaleic anhydride is

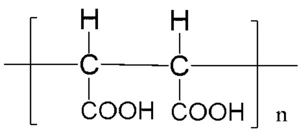

,

where the value of n is in a range of 8-25. The molecular structural formula of the maleic acid-acrylic acid copolymer is

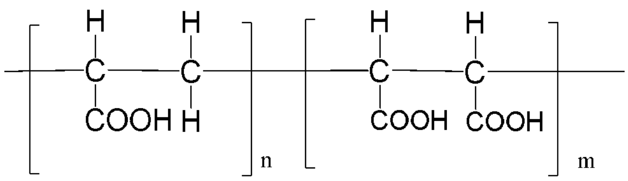

,

where the value of n is in a range of 3000-6000, and the value of m is in a range of 8-15.

In one or more embodiments of the present application, the polyacrylic acid-based complexing agent undergoes a complexing reaction with the metal cations in the perovskite material by means of a plurality of carboxylic acid groups and a plurality of hydroxyl groups contained therein, thus reducing the migration of metal ions.

In some embodiments, the perovskite light absorption layer includes a perovskite composite layer, and the perovskite composite layer includes the perovskite material and the complexing agent.

In one or more embodiments of the present application, the perovskite material and the complexing agent work together to form a perovskite composite layer, so that the complexing agent acts as a bulk passivator to passivate various defects that may occur in the perovskite composite layer during the formation of the perovskite composite layer and reduce the migration of metal ions in the perovskite material, thereby improving the device efficiency and stability of the perovskite

solar cell.

In some embodiments, the perovskite light absorption layer includes a perovskite layer and a complexing layer arranged on one side of the perovskite layer, the perovskite layer includes the perovskite material, and the complexing layer includes the complexing agent.

In the embodiments of the present application, the complexing agent is used to modify at least one surface of the perovskite layer to passivate interface defects in the perovskite layer and reduce the migration of metal ions in the perovskite to the adjacent carrier transport layer.

In one or more embodiments of the present application, the complexing agent forms a complexing layer on a surface of the perovskite layer to passivate interface defects in the perovskite layer and reduce the migration of metal ions in the perovskite material to the adjacent carrier transport layer.

In some embodiments, the perovskite light absorption layer includes a perovskite composite layer and a complexing layer. The complexing agent includes a first complexing agent and a second complexing agent. The perovskite composite layer includes the perovskite material and the first complexing agent, and the complexing layer includes the second complexing agent. The first complexing agent and the second complexing agent are the same or different.

In one or more embodiments of the present application, by means of the perovskite composite layer, the first complexing agent acts as a bulk passivator to passivate various defects that may occur in the perovskite composite layer and reduce the migration of metal ions in the perovskite material. The second complexing agent acts as an interface passivator to passivate interface defects in the perovskite composite layer and reduce the migration of metal ions in the perovskite material to the adjacent carrier transport layer. By means of the combined action of the first complexing agent and the second complexing agent, the defects in the perovskite light absorption layer are further passivated, to further passivate defects in the perovskite light absorption layer and reduce the migration of metal ions in the perovskite material, thereby improving the device efficiency and stability of the perovskite solar cell.

In some embodiments, the thickness of the perovskite layer or the perovskite composite layer is 300 nm-700 nm.

In the embodiments of the present application, the thickness of the perovskite layer or the perovskite composite layer is 300 nm-700 nm. By way of example, the thickness of the perovskite layer may be 300 nm, 400 nm, 500 nm, 600 nm, or 700 nm, or may also be 350 nm, 450 nm, 550 nm, or 650 nm, and is specifically set according to requirements.

In one or more embodiments of the present application, by providing some specific thicknesses of the perovskite layer or the perovskite composite layer, the perovskite solar cell in which the perovskite layer or the perovskite composite layer falls within the thickness range has a good device performance.

In some embodiments, the thickness of the complexing layer is 10 nm-80 nm.

In the embodiments of the present application, the thickness of the complexing layer is 10 nm-80 nm. By way of example, the thickness of the perovskite layer may be 10 nm, 30 nm, 50 nm, 60 nm, or 80 nm, or may also be 20 nm, 40 nm, or 70 nm, and is specifically set according to requirements.

In one or more embodiments of the present application, by providing some specific thicknesses of the complexing layer, on the one hand, the complexing layer within this thickness range has a good passivation effect and a good ability to reduce the migration of metal ions in the perovskite layer or the perovskite composite layer; on the other hand, the complexing layer results in a relatively small interface resistance, resulting in a relatively small impact on charge transport between the perovskite layer or the perovskite composite layer and the adjacent carrier transport layer.

In a second aspect, an embodiment of the present application provides a method for preparing a perovskite solar cell, including:

providing an intermediate member including a substrate and a first electrode layer;
forming a perovskite light absorption layer precursor on the first electrode layer, where during the formation of the perovskite light absorption layer precursor, a complexing agent is added, and the complexing agent includes one or more of a hydroxycarboxylic acid-based complexing agent, an organic phosphonic acid-based complexing agent, a polyacrylic acid-based complexing agent, and a polybutenoic acid-based complexing agent; and
annealing the perovskite light absorption layer precursor to obtain a perovskite light absorption layer.

In the embodiments of the present application, the substrate is used for bearing the first electrode layer and allows for incident light to transmit. In some embodiments, the substrate is made of a light-transmitting material. In some embodiments, the substrate is a glass material. The first electrode layer represents an output end of the perovskite solar cell. The perovskite light absorption layer is used for absorbing photon energy of sunlight to generate electron-hole pairs, and the electron-hole pairs are separated into free electrons and holes under the action of a built-in electric field. The holes are collected by an electrode layer via the hole transport layer, and the electrons are collected by the other electrode layer via the electron transport layer. The two electrode layers are connected to form a circuit to generate a photocurrent. The perovskite light absorption layer precursor represents an intermediate product of the perovskite light absorption layer, which has not undergone an annealing step. In some embodiments, the first electrode layer is made of a light-transmitting material.

In one or more embodiments of the present application, the technological parameters of annealing are: a holding treatment for 10 min-30 min at a temperature of 60°C-200°C. By way of example, the annealing temperature may be 60°C, 130°C, 165°C, or 200°C, or may also be 95°C, 150°C, or 180°C, and is rationally set according to requirements. By way of example, the annealing time may be 10 min, 20 min, or 30 min, or may also be 15 min or 25 min, and is rationally set according to requirements.

In one or more embodiments of the present application, a method for preparing a perovskite solar cell is provided, such that during the formation of the perovskite light absorption layer, the complexing agent passivates various defects that may occur in the perovskite light absorption layer and reduces the migration of metal ions in the perovskite.

In some embodiments, a first carrier transport layer is arranged between the first electrode layer and the perovskite light absorption layer, and the method for preparing the perovskite solar cell includes:

> providing an intermediate member including a substrate, a first electrode layer, and a first carrier transport layer;
> forming a perovskite light absorption layer precursor on the first carrier transport layer, where during the formation of the perovskite light absorption layer precursor, a complexing agent is added, and the complexing agent includes one or more of a hydroxycarboxylic acid-based complexing agent, an organic phosphonic acid-based complexing agent, a polyacrylic acid-based complexing agent, and a polybutenoic acid-based complexing agent.

In one or more embodiments of the present application, a method for preparing a perovskite solar cell is provided, such that during the formation of the perovskite light absorption layer, the complexing agent passivates various defects that may occur in the perovskite light absorption layer and reduces the migration of metal ions in the perovskite.

The first carrier transport layer represents one of a hole transport layer and an electron transport layer. The hole transport layer is used for collecting and transporting holes, thus realizing effective electron-hole separation. The electron transport layer is a functional layer for collecting electrons generated by the absorption of photons by the perovskite light absorption layer under light conditions.

In one or more embodiments of the present application, a method for preparing a perovskite solar cell is provided, such that during the formation of the perovskite light absorption layer, the complexing agent passivates various defects that may occur in the perovskite light absorption layer and reduces the migration of metal ions in the perovskite.

In some embodiments, the formation of the perovskite light absorption layer precursor on the first carrier transport layer includes:
applying a perovskite precursor solution containing a complexing agent to the first carrier transport layer to form a perovskite composite layer.

The perovskite precursor solution represents a liquid with a precursor forming the perovskite material as the solute. In some embodiments, the perovskite precursor solution is formed by adding lead iodide ($PbI_2$), formamidine iodide (FAI), and methylamine chloride (MACl) to dimethyl sulfoxide (DMSO) and N,N-dimethylformamide (DMF). In some embodiments, the molar ratio of lead iodide ($PbI_2$) to formamidine iodide (FAI) to methylamine chloride (MACl) is (1.4-1.6) : (0.9-1.5) : (0.3-0.6).

In one or more embodiments of the present application, the perovskite material and the complexing agent work together to form a perovskite light absorption layer, so that various defects that may occur in the perovskite material are passivated, and the migration of metal ions in the perovskite is reduced.

In some embodiments, the formation of the perovskite light absorption layer precursor on the first carrier transport layer includes:
applying a perovskite precursor solution containing a complexing agent to the first carrier transport layer, where the concentration of the complexing agent in the perovskite precursor solution containing the complexing agent is less than or equal to 10% of the concentration of a cation in position B in the perovskite precursor.

In one or more embodiments of the present application, the concentration of the complexing agent in the perovskite precursor solution containing the complexing agent is less than or equal to 10% of the concentration of a cation in position B in the perovskite precursor, so that the effect of passivating interface defects between the perovskite layer and the carrier transport layer is better, thereby effectively improving the device efficiency and stability of the perovskite solar cell. By way of example, the concentration of the complexing agent in the perovskite precursor solution containing the complexing agent is 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, or 10% of the concentration of a cation in position B in the perovskite precursor, or may also be 0.1%-1.5%, 1.4%-4%, 3.5%-6%, 5%-8%, or 6.5%-10%, and is rationally set according to requirements.

The presence of the complexing agent in the perovskite light absorption layer can be characterized by X-ray

photoelectron spectroscopy (XPS). By this characterization means, X-rays are used to radiate the perovskite light absorption layer to be characterized, so that the inner electrons or valence electrons of atoms or molecules are excited and then emitted. Electrons excited by photons are referred to as photoelectrons. By measuring the energy of photoelectrons, a corresponding photoelectron spectrum can be made, with the kinetic energy/binding energy of photoelectrons as the abscissa and the relative intensity as the ordinate. By analyzing the photoelectron spectrum, the relevant information about the elemental composition and the contents of the elements, the chemical state, the molecular structure, the chemical bond, etc., in the perovskite light absorption layer to be characterized can be obtained. The presence of the complexing agent in the perovskite light absorption layer is qualitatively characterized by the characterized relevant information. After other layers are peeled off the perovskite light absorption layer, the perovskite light absorption layer is dissolved with the solvent DMF, and the contents of the perovskite layer and the complexing agent can be determined by liquid chromatography.

In one or more embodiments of the present application, the addition amount of the complexing agent in the perovskite precursor solution is adjusted to passivate various defects that may occur in the perovskite material and reduce the migration of metal ions in the perovskite.

In some embodiments, the formation of the perovskite light absorption layer precursor on the first carrier transport layer includes:

forming a perovskite layer on the first carrier transport layer; and
applying a complexing agent solution to a surface of the perovskite layer away from the first carrier transport layer.

In the embodiments of the present application, the complexing agent solution represents a solution with the complexing agent as the solute. The solvent in the complexing agent solution is specifically selected according to the properties of the complexing agent. In some embodiments, the solvent in the complexing agent solution can be selected from polar solvents such as methanol, ethanol, and isopropanol.

In one or more embodiments of the present application, by means of the provided method for forming the complexing layer on the perovskite layer, possible interface defects between the perovskite layer and the adjacent carrier transport layer are passivated, and the migration of metal ions in the perovskite material to the adjacent carrier transport layer is reduced, thus improving the device efficiency and stability of the perovskite solar cell.

In some embodiments, the concentration of the complexing agent solution is greater than 0 and less than or equal to 20 mg/ml.

In one or more embodiments of the present application, the concentration of the complexing agent solution is greater than 0 and less than or equal to 20 mg/ml, which results in a good ability to passivate interface defects and hinder ion migration. By way of example, the concentration of the complexing agent solution may be 1 mg/ml, 2 mg/ml, 5 mg/ml, 10 mg/ml, 15 mg/ml, 20 mg/ml, or may also be 3 mg/ml, 7 mg/ml, 12 mg/ml, 16 mg/ml, 18 mg/ml, and is rationally set according to requirements.

In some embodiments, the formation of the perovskite light absorption layer precursor on the first carrier transport layer includes:

applying a perovskite precursor solution containing a complexing agent to the first carrier transport layer to form a perovskite composite layer, where the concentration of the complexing agent in the perovskite precursor solution containing the complexing agent is less than or equal to 10% of the concentration of a cation in position B in the perovskite precursor; and
applying a complexing agent solution to a surface of the perovskite composite layer away from the first carrier transport layer.

In one or more embodiments of the present application, the concentration of the complexing agent in the perovskite precursor solution containing the complexing agent is less than or equal to 10% of the concentration of a cation in position B in the perovskite precursor, so that the effect of passivating interface defects between the perovskite composite layer and the carrier transport layer is better, thereby effectively improving the device efficiency and stability of the perovskite solar cell. By way of example, the concentration of the complexing agent in the perovskite precursor solution containing the complexing agent is 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, *5%, 5.1%,* 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, or 10% of the cation in position B in the perovskite precursor, or may also be 0.1%-1.5%, 1.4%-4%, 3.5%-6%, 5%-8%, or 6.5%-10%, and is rationally set according to requirements.

In one or more embodiments of the present application, by means of the provided complexing agent participating

in the formation of the perovskite composite layer and the formation of the complexing layer on the surface of the perovskite composite layer, not only can reduced defects in the bulk phase of the perovskite material and reduced migration of metal ions in the perovskite material be achieved, but also interface defects in the perovskite composite layer can be reduced and the migration of ions in the perovskite material to the adjacent carrier transport layer can be further reduced, thereby improving the photoelectric conversion effect and/or stability of the corresponding perovskite solar cell.

Referring to FIG. 1, FIG. 1 is a schematic view of a first structure of a perovskite solar cell provided by an embodiment of the present application.

An embodiment of the present application provides a perovskite solar cell 100, including a substrate 10, a first electrode layer 20, a perovskite light absorption layer 30, and a second electrode layer 40, which are stacked in order.

In the embodiments of the present application, the substrate 10 is used for bearing the first electrode layer 20, the perovskite light absorption layer 30, and the second electrode layer 40 and allows for incident light to transmit. In some embodiments, the substrate 10 is made of a light-transmitting material. In some embodiments, the light-transmitting material is glass. The first electrode layer 20 represents an output end of the perovskite solar cell 100. The perovskite light absorption layer 30 is used for absorbing photon energy of sunlight to generate electron-hole pairs, and the electron-hole pairs are separated into free electrons and holes under the action of a built-in electric field. The holes are collected by an electrode layer via the hole transport layer, and the electrons are collected by the other electrode layer via the electron transport layer. The two electrode layers are connected to form a circuit to generate a photocurrent. The second electrode layer 40 represents another output end of the perovskite solar cell 100, which requires a high conductivity and stability. In some embodiments, the first electrode layer 20 is made of a light-transmitting material. In some embodiments, the second electrode layer 40 may be made of either a light-transmitting material or an opaque material.

In one or more embodiments of the present application, by providing some specific structures of the perovskite solar cell 100, the first electrode layer 20 and the second electrode layer 40 can form a current loop in an external manner to drive a load or store electricity.

Referring to FIG. 2, FIG. 2 is a schematic view of a second structure of a perovskite solar cell provided by an embodiment of the present application.

In some embodiments, referring to FIG. 2, an embodiment of the present application provides a perovskite solar cell 100. In addition to the structure shown in FIG. 1, the perovskite solar cell further includes a carrier transport layer 50. The carrier transport layer 50 can include a first carrier transport layer 51 arranged between the first electrode layer 20 and the perovskite light absorption layer 30 or a second carrier transport layer 52 arranged between the second electrode layer 40 and the perovskite light absorption layer 30.

The carrier transport layer 50 represents a functional layer for collecting electrons or holes generated by the absorption of photons by the perovskite light absorption layer 30 under light conditions. In some embodiments, the first carrier transport layer 51 is an electron transport layer, the second carrier transport layer 52 is a hole transport layer, and the corresponding perovskite solar cell 100 is a normal device. In some embodiments, the first carrier transport layer 51 is a hole transport layer, the second carrier transport layer 52 is an electron transport layer, and the corresponding perovskite solar cell 100 is an inverted device.

In one or more embodiments of the present application, the carrier transport layer 50 arranged in the perovskite solar cell 100 helps to transport electron-hole pairs excited by photons in the perovskite light absorption layer 30 to the first electrode layer 20 and/or the second electrode layer 40, so that non-radiative recombination of electron-hole pairs in the perovskite light absorption layer 30 are reduced while defects are passivated, thus improving the device efficiency.

Referring to FIGs. 3 to 4, FIG. 3 is a schematic view of a third structure of a perovskite solar cell provided by an embodiment of the present application, and FIG. 4 is a schematic view of a fourth structure of a perovskite solar cell provided by an embodiment of the present application.

In some embodiments, referring to FIG. 3, the perovskite light absorption layer 30 includes a perovskite layer 31 and a complexing layer 32. The perovskite layer 31 is formed by applying a perovskite precursor solution to the first carrier transport layer 51. The complexing layer 32 is formed by applying a complexing agent solution to a surface of the perovskite layer away from the first carrier transport layer. The complexing agent includes one or more of a hydroxycarboxylic acid-based complexing agent, an organic phosphonic acid-based complexing agent, a polyacrylic acid-based complexing agent, and a polybutenoic acid-based complexing agent.

In some embodiments, referring to FIG. 4, the perovskite light absorption layer 30 includes a perovskite composite layer 33 and a complexing layer 32. The perovskite composite layer 33 is formed by applying a perovskite precursor solution containing a first complexing agent to the first carrier transport layer 51, and the complexing layer 32 is formed by applying a second complexing agent to a surface of the perovskite composite layer 33 away from the first carrier transport layer. The first complexing agent and the second complexing agent are independently selected from one or more of a hydroxycarboxylic acid-based complexing agent, an organic phosphonic acid-based complexing agent, polyacrylic acid-based complexing agent, and a polybutenoic acid-based complexing agent.

Referring to FIG. 5, FIG. 5 is a schematic structural view of a photovoltaic module provided by an embodiment of the present application.

In a third aspect, referring to FIG. 5, an embodiment of the present application provides a photovoltaic module 1000, including any perovskite solar cell 100 provided in the first aspect or a perovskite solar cell 100 prepared by any method for preparing a perovskite solar cell 100 as provided in the second aspect or the third aspect.

In the embodiments of the present application, the photovoltaic module 1000 represents an integral assembly including a plurality of perovskite solar cells 100. A plurality of cell strings 200 are included, and each cell string 200 includes a plurality of perovskite solar cells 100 connected in series via connectors such as welding strips.

In addition to the cell strings 200, the photovoltaic module 1000 further includes front glass 300, a front encapsulation film 400, a back encapsulation film 500, a back glass 600, etc. By way of example, the photovoltaic module 1000 includes front glass 300, a front encapsulation film 400, a cell string 200, a back encapsulation film 500, and back glass 600, which are sequentially stacked and distributed along the thickness direction.

Referring to FIG. 6, FIG. 6 is a schematic structural view of a power generation apparatus provided by an embodiment of the present application.

In a fourth aspect, referring to FIG. 6, an embodiment of the present application provides a power generation apparatus 2000 including the photovoltaic module 1000 provided in the third aspect. The power generation apparatus 2000 in which the photovoltaic module 1000 provided by the present application is used has at least the same advantages as the photovoltaic module 1000, so that the power consumption performance of the power generation apparatus 2000 can be improved.

In an embodiment of the present application, the photovoltaic module 1000 acts as an energy source for the power generation apparatus 2000 to realize the output of electrical energy from the power generation apparatus 2000. The power generation apparatus 2000 in which the photovoltaic module 1000 provided by the present application is used has at least the same advantages as the photovoltaic module 1000, so that the power generation performance of the power generation apparatus 2000 can be improved. By way of example, the power generation apparatus 2000 can be applied to the fields of building electricity, wearable device electricity, smart phone electricity, in-vehicle battery electricity, etc.

Referring to FIG. 7, FIG. 7 is a schematic structural view of an electrical device provided by an embodiment of the present application.

In a fifth aspect, referring to FIG. 7, an embodiment of the present application provides an electrical device 3000 including the photovoltaic module 1000 provided in the third aspect. The electrical device 3000 in which the photovoltaic module 1000 provided by the present application is used has at least the same advantages as the photovoltaic module 1000, so that the cell performance of the electrical device 3000 can be improved.

The features and performance of the present application will be further described below in detail with reference to embodiments.

Embodiment 1

A perovskite solar cell 100 was prepared, including the following steps:

Step (1): A substrate 10 was ultrasonically cleaned successively with anhydrous ethanol, acetone, and isopropanol and blown to dryness.

Step (2): The cleaned substrate 10 was treated with ultraviolet ozone for 10 min-20 min to prepare a first electrode layer 20. The material of the first electrode layer 20 was FTO (fluorine-doped tin dioxide).

Step (3): Preparation of first carrier transport layer 51: The prepared first electrode layer 20 was spin-coated with an $SnO_2$ hydrocolloid dispersion with a mass fraction of 15% at a speed of 4000 rpm, followed by an annealing treatment on a hot stage at 150°C for 10 min to obtain a first carrier transport layer 51 (electron transport layer) with a thickness of 30 nm.

Step (4): Preparation of perovskite composite layer 33: A surface of the first carrier transport layer 51 away from the first electrode layer 20 was spin-coated with a perovskite precursor solution containing a complexing agent at a speed of 4000 rpm for 15 s, and 600 μL of chlorobenzene was dropwise added as an anti-solvent at the 10th second after spin-coating was started, followed by annealing on a hot stage at 100°C for 60 min to obtain a perovskite composite layer 33 with a thickness of 500 nm. The perovskite precursor solution containing a complexing agent was formed by adding 705.34 mg of $PbI_2$, 240.8 mg of FAI, 33.78 mg of MACl, and 2.30 mg of tartaric acid to 100 μL of DMSO (dimethyl sulfoxide) and 900 μL of DMF (N,N-dimethylformamide) and stirred for 8 h-12 h.

Step (5): Preparation of second carrier transport layer 52: 72.3 mg of spiro-OMeTAD (2,2',7,7'-tetrakis[N,N-bis(4-methoxyphenyl)amino]-9,9'-spirobifluorene) was dissolved in 1 mL of chlorobenzene and stirred until fully dissolved; Li-TFSI (lithium bis(trifluoromethane)sulfonimide) was added to acetonitrile and stirred and mixed uniformly to obtain an Li-TFSI solution with a mass concentration of 520 mg/mL; and 18 μL of the Li-TFSI solution and 29 μL of 4-tert-butylpyridine (tBP) were added to 1 mL of the spiro-OMeTAD solution, and stirred and mixed uniformly to obtain mixed solution A. 100 μL of mixed solution A was taken, and a surface of the perovskite light absorption layer 30 away from the first carrier transport layer 51 was spin-coated with the mixed solution A at a speed of 4000 rpm, followed by an

annealing treatment on a hot stage at 150°C for 10 min to obtain a second carrier transport layer 52 with a thickness of about 100 nm.

Step (6): Preparation of second electrode layer 40: The thin film prepared with the second carrier transport layer 52 was evaporated with Au atoms on the surface of the second carrier transport layer 52 at a rate of 0.1 A/s in a vacuum environment to form a second electrode layer 40 with an average thickness of 80 nm.

The perovskite solar cell 100 prepared in this embodiment was denoted as sample 1.

Embodiment 2

This embodiment provided a method for preparing a perovskite solar cell 100, which was different from Embodiment 1 in that

in the perovskite precursor solution containing the complexing agent in step (4), the concentration of tartaric acid was 0.0765 mmol/mL and the mass was 11.48 mg.

The rest were all the same as in Embodiment 1.

The perovskite solar cell 100 prepared in this embodiment was denoted as sample 2.

Embodiment 3

This embodiment provided a method for preparing a perovskite solar cell 100, which was different from Embodiment 1 in that

in the perovskite precursor solution containing the complexing agent in step (4), the concentration of tartaric acid was 0.1224 mmol/mL and the mass was 18.37 mg.

The rest were all the same as in Embodiment 1.

The perovskite solar cell 100 prepared in this embodiment was denoted as sample 3.

Embodiment 4

This embodiment provided a method for preparing a perovskite solar cell 100, which was different from Embodiment 1 in that

in step (3), the prepared first electrode layer 20 was spin-coated with 2 mg/mL PTAA (poly[bis(4-phenyl)(2,4,6-trimethylphenyl)amine]) at a speed of 5000 rpm/s for a spin-coating time length of 30 s, followed by an annealing treatment on a hot stage at 100°C for 10 minutes to form a second carrier transport layer 52 (hole transport layer) with a thickness of 50 nm.

In step (5), the prepared substrate was put into an evaporation instrument, and when the evaporation vacuum degree reached $5 \times 10^{-4}$ Pa or less, a surface of the perovskite light absorption layer 30 was evaporated with C60 (carbon 60) with a thickness of 30 nm at a rate of 0.05 A/s to form a first carrier transport layer 51 (electron transport layer).

The rest were all the same as in Embodiment 1.

The perovskite solar cell 100 prepared in this embodiment was denoted as sample 4.

Embodiment 5

This embodiment provided a method for preparing a perovskite solar cell 100, which was different from Embodiment 1 in:

(1) during the formation of the perovskite precursor solution in step (4) of this embodiment, no tartaric acid was added. It should be noted that the formula of the precursor components in the perovskite precursor solution formed in step (4) of this embodiment and each process used during the preparation thereof were both the same as the formula of the precursor components in the perovskite precursor solution formed in step (4) of Embodiment 1 and each process used during the preparation thereof.

(2) After the perovskite layer 31 was formed in step (4) of this embodiment, a surface of the perovskite layer 31 away from the first carrier transport layer 51 was spin-coated with 1 mg/ml tartaric acid for 15 s at 4000 rpm, followed by annealing on a hot stage at 100°C for 60 min to obtain a complexing layer 32 with a thickness of 10 nm.

The rest were all the same as in Embodiment 1.

The perovskite solar cell 100 prepared in this embodiment was denoted as sample 5.

Embodiment 6

This embodiment provided a method for preparing a perovskite solar cell 100, which was different from Embodiment 5 in that
in step (4), the concentration of tartaric acid was 5 mg/ml.

The rest were all the same as in Embodiment 5.

The perovskite solar cell 100 prepared in this embodiment was denoted as sample 6.

Embodiment 7

This embodiment provided a method for preparing a perovskite solar cell 100, which was different from Embodiment 5 in that
in step (4), the concentration of tartaric acid was 20 mg/ml.

The rest were all the same as in Embodiment 5.

The perovskite solar cell 100 prepared in this embodiment was denoted as sample 7.

Embodiment 8

This embodiment provided a method for preparing a perovskite solar cell 100, which was different from Embodiment 3 in that

After the perovskite composite layer 33 was formed in step (4) of this embodiment, a surface of the perovskite composite layer 33 away from the first carrier transport layer 51 was spin-coated with 5 mg/ml tartaric acid for 15 s at 4000 rpm, followed by annealing on a hot stage at 100°C for 60 min to obtain a complexing layer 32 with a thickness of 10 nm. It needs to be noted that the formula of the perovskite composite layer 33 formed in step (4) of this embodiment and each process parameter used during the preparation thereof were both the same as the formula of the perovskite composite layer 33 formed in step (4) of Embodiment 3 and each process parameter used during the preparation thereof.

The rest were all the same as in Embodiment 3.

The perovskite solar cell 100 prepared in this embodiment was denoted as sample 8.

Embodiment 9

This embodiment provided a method for preparing a perovskite solar cell 100, which was different from Embodiment 3 in that
in the perovskite precursor solution containing the complexing agent in step (4), the complexing agent was sodium heptonate.

The rest were all the same as in Embodiment 3.

The perovskite solar cell 100 prepared in this embodiment was denoted as sample 9.

Embodiment 10

This embodiment provided a method for preparing a perovskite solar cell 100, which was different from Embodiment 3 in that
in the perovskite precursor solution containing the complexing agent in step (4), the complexing agent was sodium gluconate.

The rest were all the same as in Embodiment 3.

The perovskite solar cell 100 prepared in this embodiment was denoted as sample 10.

Embodiment 11

This embodiment provided a method for preparing a perovskite solar cell 100, which was different from Embodiment 3 in that
in the perovskite precursor solution containing the complexing agent in step (4), the complexing agent was sodium alginate with a weight average molecular weight of 1000.

The rest were all the same as in Embodiment 3.

The perovskite solar cell 100 prepared in this embodiment was denoted as sample 11.

Embodiment 12

This embodiment provided a method for preparing a perovskite solar cell 100, which was different from Embodiment 3 in that
in the perovskite precursor solution containing the complexing agent in step (4), the complexing agent was sodium ethylenediamine tetramethylene phosphonate.
The rest were all the same as in Embodiment 3.
The perovskite solar cell 100 prepared in this embodiment was denoted as sample 12.

Embodiment 13

This embodiment provided a method for preparing a perovskite solar cell 100, which was different from Embodiment 3 in that
in the perovskite precursor solution containing the complexing agent in step (4), the complexing agent was hydroxyethylidene diphosphonic acid.
The rest were all the same as in Embodiment 3.
The perovskite solar cell 100 prepared in this embodiment was denoted as sample 13.

Embodiment 14

This embodiment provided a method for preparing a perovskite solar cell 100, which was different from Embodiment 3 in that
in the perovskite precursor solution containing the complexing agent in step (4), the complexing agent was sodium diethylenetriamine pentamethylene phosphonate.
The rest were all the same as in Embodiment 3.
The perovskite solar cell 100 prepared in this embodiment was denoted as sample 14.

Embodiment 15

This embodiment provided a method for preparing a perovskite solar cell 100, which was different from Embodiment 3 in that
in the perovskite precursor solution containing the complexing agent in step (4), the complexing agent was aminotrimethylene phosphonic acid.
The rest were all the same as in Embodiment 3.
The perovskite solar cell 100 prepared in this embodiment was denoted as sample 15.

Embodiment 16

This embodiment provided a method for preparing a perovskite solar cell 100, which was different from Embodiment 3 in that
in the perovskite precursor solution containing the complexing agent in step (4), the complexing agent was polyacrylic acid with a weight average molecular weight of 450000.
The rest were all the same as in Embodiment 3.
The perovskite solar cell 100 prepared in this embodiment was denoted as sample 16.

Embodiment 17

This embodiment provided a method for preparing a perovskite solar cell 100, which was different from Embodiment 3 in that
in the perovskite precursor solution containing the complexing agent in step (4), the complexing agent was polyhydroxyacrylic acid with a weight average molecular weight of 520000.
The rest were all the same as in Embodiment 3.
The perovskite solar cell 100 prepared in this embodiment was denoted as sample 17.

Embodiment 18

This embodiment provided a method for preparing a perovskite solar cell 100, which was different from Embodiment 3 in that

in the perovskite precursor solution containing the complexing agent in step (4), the complexing agent was polyacrylamide with a weight average molecular weight of 40000.

The rest were all the same as in Embodiment 3.

The perovskite solar cell 100 prepared in this embodiment was denoted as sample 18.

Embodiment 19

This embodiment provided a method for preparing a perovskite solar cell 100, which was different from Embodiment 3 in that

in the perovskite precursor solution containing the complexing agent in step (4), the complexing agent was polymaleic anhydride with a weight average molecular weight of 2000.

The rest were all the same as in Embodiment 3.

The perovskite solar cell 100 prepared in this embodiment was denoted as sample 19.

Comparative Example 1

This comparative example provided a method for preparing a perovskite solar cell 100, which was different from Embodiment 1 in that

in step (4), no complexing agent was added.

The rest were all the same as in Embodiment 1.

The perovskite solar cell 100 prepared in this comparative example was denoted as control sample 1.

Comparative Example 2

This comparative example provided a method for preparing a perovskite solar cell 100, which was different from Embodiment 4 in that

in step (4), no complexing agent was added.

The rest were all the same as in Embodiment 4.

The perovskite solar cell 100 prepared in this comparative example was denoted as control sample 2.

The perovskite solar cells 100 prepared in Embodiments 1-19 and the perovskite solar cells 100 prepared in Comparative Examples 1-2 were tested for photoelectric conversion efficiency and stability. The test results are as shown in Table 1.

In this experimental example, the photoelectric conversion efficiency of the perovskite solar cell 100 prepared in each of the embodiments and comparative examples was tested by Keithley 2400SMU AM1.5G solar irradiation, and the photoelectric conversion efficiency of the cell was tested under a light source of 100 mW/cm$^2$. The calculation method for the photoelectric conversion efficiency (PCE) was as follows:

$$\begin{aligned} PCE &= Pout/Popt \\ &= Voc \times Jsc \times (Vmpp \times Jmpp)/(Voc \times Jsc) \\ &= Voc \times Jsc \times FF \end{aligned}$$

where Pout, Popt, Vmpp, Jmpp, Voc, and Jsc were the working output power of the cell, the incident light power, the maximum power point voltage of the cell, the maximum power point current of the cell, the open circuit voltage, and the short circuit current, respectively. FF represented fill factor.

In this experimental example, the stability test for the perovskite solar cell 100 prepared in each of the embodiments and comparative examples was as follows: the perovskite solar cell 100 was placed under the environmental conditions of a temperature of 25°C and a relative humidity of 45% $\pm$ 5%. With the change of the aging time, the photoelectric conversion efficiency (PCE) thereof at several time nodes was traced. The time required for the photoelectric conversion efficiency thereof to decay to 80% of the initial efficiency was denoted as $T_{80}$. The value of this parameter indicated the level of the stability of the perovskite solar cell 100.

Table 1 Performance test data of the perovskite solar cells 100 prepared in the embodiments and comparative examples of the present application ("/" represented no addition)

| Item | Complexing agent | Passivation type | Cell configuration | Concentration of complexing agent in perovskite layer | Concentration of complexing agent in complex layer | PCE % | Voc V | Jsc $mA.cm^{-2}$ | FF % | $T_{80}$ h |
|---|---|---|---|---|---|---|---|---|---|---|
| Control sample 1 | No complexing agent added | - | Normal | / | / | 21.83 | 1.13 | 23.6 | 81.84 | 426 |
| Control sample 2 | No complexing agent added | - | Inverted | / | / | 19.12 | 1.07 | 23.25 | 76.84 | 536 |
| Sample 1 | Tartaric acid | Bulk passivation | Normal | 0.0153 mmol/mL | / | 22.17 | 1.13 | 23.97 | 81.85 | 498 |
| Sample 2 | Tartaric acid | Bulk passivation | Normal | 0.0765 mmol/mL | / | 22.45 | 1.13 | 24.39 | 81.46 | 551 |
| Sample 3 | Tartaric acid | Bulk passivation | Normal | 0.1224 mmol/mL | / | 22.76 | 1.14 | 24.84 | 80.37 | 594 |
| Sample 4 | Tartaric acid | Bulk passivation | Inverted | 0.0153 mmol/mL | / | 20.60 | 1.09 | 24.21 | 78.08 | 653 |
| Sample 5 | Tartaric acid | Interface passivation | Normal | / | 1 mg/ml | 22.65 | 1.14 | 24.76 | 80.24 | 502 |
| Sample 6 | Tartaric acid | Interface passivation | Normal | / | 5 mg/ml | 23.22 | 1.16 | 24.73 | 80.95 | 579 |
| Sample 7 | Tartaric acid | Interface passivation | Normal | / | 20 mg/ml | 22.57 | 1.16 | 23.81 | 81.71 | 647 |
| Sample 8 | Tartaric acid | Bulk passivation and interface passivation | Normal | 0.1224 mmol/mL | 5 mg/ml | 22.81 | 1.17 | 23.79 | 81.95 | 691 |
| Sample 9 | Sodium heptonate | Bulk passivation | Normal | 0.1224 mmol/mL | / | 23.01 | 1.15 | 24.55 | 81.51 | 614 |
| Sample 10 | Sodium gluconate | Bulk passivation | Normal | 0.1224 mmol/mL | / | 22.87 | 1.14 | 24.47 | 81.99 | 638 |
| Sample 11 | Sodium alginate | Bulk passivation | Normal | 0.1224 mmol/mL | / | 22.72 | 1.14 | 24.37 | 81.8 | 625 |

(continued)

| Item | Complexing agent | Passivation type | Cell configuration | Concentration of complexing agent in perovskite layer | Concentration of complexing agent in complex layer | PCE % | Voc V | Jsc $mA.cm^{-2}$ | FF % | $T_{80}$ h |
|---|---|---|---|---|---|---|---|---|---|---|
| Sample 12 | Sodium ethylenediamine tetramethylene phosphonate | Bulk passivation | Normal | 0.1224 mmol/mL | / | 22.44 | 1.15 | 24.71 | 78.99 | 679 |
| Sample 13 | Hydroxyethylidene diphosphonic acid | Bulk passivation | Normal | 0.1224 mmol/mL | / | 22.36 | 1.14 | 24.54 | 79.95 | 663 |
| Sample 14 | Diethylenetriamine pentamethylene phosphonate | Bulk passivation | Normal | 0.1224 mmol/mL | / | 22.63 | 1.15 | 24.35 | 80.81 | 692 |
| Sample 15 | Aminotrimethylene phosphonic acid | Bulk passivation | Normal | 0.1224 mmol/mL | / | 22.80 | 1.14 | 24.65 | 81.14 | 681 |
| Sample 16 | Polyacrylic acid | Bulk passivation | Normal | 0.1224 mmol/mL | / | 22.45 | 1.14 | 24.33 | 80.94 | 709 |
| Sample 17 | Polyhydroxyacrylic acid | Bulk passivation | Normal | 0.1224 mmol/mL | / | 23.06 | 1.15 | 24.75 | 81.01 | 697 |
| Sample 18 | Polyacrylamide | Bulk passivation | Normal | 0.1224 mmol/mL | / | 22.90 | 1.14 | 24.67 | 81.41 | 722 |
| Sample 19 | Polymaleic anhydride | Bulk passivation | Normal | 0.1224 mmol/mL | / | 22.85 | 1.15 | 24.69 | 80.46 | 719 |

According to the analysis of the test results obtained in Table 1, the following conclusions can be derived.

As can be seen according to the analysis of the test results of Embodiments 1-3, with the increase of the concentration of the complexing agent, the photoelectric conversion efficiency and stability of the perovskite solar cell 100 increased accordingly.

As can be seen according to the analysis of the test results of Embodiments 1-3 and Comparative Example 1, compared with the normal perovskite solar cell 100 in which no complexing agent was added, the normal perovskite solar cell 100 in which the complexing agent was added exhibited a significant improvement in both photoelectric conversion efficiency and stability.

As can be seen according to the analysis of the test results of Embodiment 4 and Comparative Example 2, compared with the inverted perovskite solar cell 100 in which no complexing agent was added, the inverted perovskite solar cell 100 in which the complexing agent was added exhibited a significant improvement in both photoelectric conversion efficiency and stability.

As can be seen according to the analysis of the test results of Embodiment 4 and Embodiment 3, compared with the normal perovskite solar cell 100, the formed inverted perovskite solar cell 100 in which tartaric acid was used as a complexing agent exhibited a certain decrease in photoelectric conversion efficiency but a certain improvement in stability.

As can be seen according to the analysis of the test results of Embodiment 5 and Comparative Example 1, compared with the perovskite solar cell 100 in which no complexing agent was added, the distribution of the complexing agent on the surface of the perovskite layer 31 exhibited a significant improvement in both photoelectric conversion efficiency and stability.

As can be seen according to the analysis of the test results of Embodiments 5-7, with the increase of the concentration of the complexing agent, the photoelectric conversion efficiency of the perovskite solar cell 100 showed a trend of first increasing and then decreasing, while the stability showed a trend of increasing.

As can be seen according to the analysis of the test results of Embodiment 8 and Embodiments 3 and 6, compared with the use of the complexing agent only as an interface passivator or a bulk passivator, the use of the complexing agent as both an interface passivator and a bulk passivator resulted in the perovskite solar cell 100 corresponding thereto showing a fluctuation of the photoelectric conversion efficiency within a certain range and a significantly improved stability.

As can be seen according to the analysis of the test results of Embodiments 9-19 and Embodiment 3, compared with the normal perovskite solar cell 100 formed using the hydroxycarboxylic acid-based complexing agent, the normal perovskite solar cells 100 formed using the organic phosphonic acid-based complexing agent, the polyacrylic acid-based complexing agent, and the polybutenoic acid-based complexing agent exhibited a significant improvement in stability and a fluctuation of the photoelectric conversion efficiency within a small range.

In summary, compared with the perovskite solar cell 100 in which no complexing agent was included, the perovskite solar cell 100 provided by the embodiments of the present application in which a complexing agent was included exhibited a good improvement in both device efficiency and stability.

In the plurality of embodiments provided by the present application, it should be understood that the disclosed systems, devices, and methods can be implemented in other ways. For example, the device embodiments described above are only schematic. For example, the division of units is only a logical function division. During actual implementation, there may be other division methods, for example, a plurality of units or components can be combined or integrated into another system, or some features can be ignored or not implemented. In addition, the mutual coupling or direct coupling or communication connection as shown or discussed can be indirect coupling or communication connection via some interfaces, devices or units, which can be in electrical, mechanical or other forms.

In addition, each functional unit in each embodiment of the present application can be integrated into one processing unit, or each unit can exist physically alone, or two or more units can be integrated into one unit. The above integrated units can be implemented either in the form of hardware or in the form of software functional units.

The above description is only the embodiments of the present application, which does not limit the patent scope of the present application. Any equivalent structures or equivalent process transformations made by using the contents of the specification of the present application and the accompanying drawings, or directly or indirectly applied to other related technical fields, are equally included in the patent scope of protection of the present application.

## Claims

1. A perovskite solar cell, comprising a perovskite light absorption layer, wherein the perovskite light absorption layer comprises a perovskite material and a complexing agent, and the complexing agent comprises one or more of a hydroxycarboxylic acid-based complexing agent, an organic phosphonic acid-based complexing agent, a polyacrylic acid-based complexing agent, and a polybutenoic acid-based complexing agent.

**2.** The perovskite solar cell according to claim 1, wherein
the hydroxycarboxylic acid-based complexing agent comprises one or more of a carboxylic acid with a structural formula of

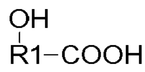

and a carboxylate with a structural formula of

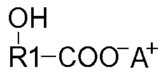,

wherein R1 is any one of a linear hydrocarbon group, a linear hydrocarbon group containing a heteroatom, aryl, heteroaryl, a cyclic hydrocarbon group, and a cyclic hydrocarbon group containing a heteroatom; the heteroatom comprises an oxygen atom; and $A^+$ comprises any one of $Na^+$, $K^+$, and $NH_4^+$.

**3.** The perovskite solar cell according to claim 2, wherein the group R1 comprises at least one functional group, and the functional group comprises one or two of hydroxyl and carboxyl.

**4.** The perovskite solar cell according to any one of claims 1-3, wherein the hydroxycarboxylic acid-based complexing agent comprises one or more of tartaric acid, heptonic acid, gluconic acid, and alginic acid; and/or
the hydroxycarboxylic acid-based complexing agent comprises one or more of a sodium salt, a potassium salt, and an ammonium salt of tartaric acid, heptonic acid, gluconic acid, and alginic acid.

**5.** The perovskite solar cell according to claim 1, wherein
the organic phosphonic acid-based complexing agent comprises one or more of an organic phosphonic acid with a structural formula of

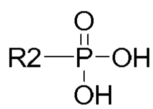

and an organic phosphonate with a structural formula of

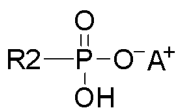,

wherein R2 is any one of a linear hydrocarbon group and a linear hydrocarbon group containing a heteroatom; the heteroatom comprises one or more of a nitrogen atom, a phosphorus atom, and an oxygen atom; and $A^+$ comprises any one of $Na^+$, $K^+$, and $NH_4^+$.

**6.** The perovskite solar cell according to claim 5, wherein R2 comprises at least one functional group, and the functional group comprises one or more of a phosphonic acid group, hydroxyl, a carbon-carbon double bond, and amino.

**7.** The perovskite solar cell according to claim 5 or 6, wherein the organic phosphonic acid-based complexing agent comprises one or more of ethylenediamine tetramethylene phosphonic acid, hydroxyethylidene diphosphonic acid, diethylenetriamine pentamethylene phosphonic acid, and aminotrimethylene phosphonic acid; and/or
the organic phosphonic acid-based complexing agent comprises one or more of a sodium salt, a potassium salt, and an ammonium salt of ethylenediamine tetramethylene phosphonic acid, hydroxyethylidene diphosphonic acid, diethylenetriamine pentamethylene phosphonic acid, and aminotrimethylene phosphonic acid.

**8.** The perovskite solar cell according to claim 1, wherein the polyacrylic acid-based complexing agent comprises one or more of polyacrylic acid, polyhydroxyacrylic acid, and polyacrylamide; and/or

the polybutenoic acid-based complexing agent comprises one or more of polymaleic anhydride and a maleic acid-acrylic acid copolymer.

**9.** The perovskite solar cell according to any one of claims 1-8, wherein the perovskite light absorption layer comprises a perovskite composite layer, and the perovskite composite layer comprises the perovskite material and the complexing agent.

**10.** The perovskite solar cell according to any one of claims 1-8, wherein the perovskite light absorption layer comprises a perovskite layer and a complexing layer arranged on one side of the perovskite layer, the perovskite layer comprises the perovskite material, and the complexing layer comprises the complexing agent.

**11.** The perovskite solar cell according to any one of claims 1-8, wherein the perovskite light absorption layer comprises a perovskite composite layer and a complexing layer; the complexing agent comprises a first complexing agent and a second complexing agent; the perovskite composite layer comprises the perovskite material and the first complexing agent, and the complexing layer comprises the second complexing agent; and the first complexing agent and the second complexing agent are the same or different.

**12.** The perovskite solar cell according to any one of claims 9-11, wherein a thickness of the perovskite layer or the perovskite composite layer is 300 nm-700 nm.

**13.** The perovskite solar cell according to any one of claims 10-12, wherein a thickness of the complexing layer is 10 nm-80 nm.

**14.** The perovskite solar cell according to any one of claims 1-13, wherein the perovskite solar cell comprises a substrate, a first electrode layer, a perovskite light absorption layer, and a second electrode layer, which are stacked in order.

**15.** The perovskite solar cell according to claim 14, wherein the perovskite solar cell further comprises a carrier transport layer, and the carrier transport layer is arranged between the first electrode layer and the perovskite light absorption layer and/or arranged between the second electrode layer and the perovskite light absorption layer.

**16.** A method for preparing a perovskite solar cell, comprising:

providing an intermediate member comprising a substrate and a first electrode layer;
forming a perovskite light absorption layer precursor on the first electrode layer, wherein during the formation of the perovskite light absorption layer precursor, a complexing agent is added, and the complexing agent comprises one or more of a hydroxycarboxylic acid-based complexing agent, an organic phosphonic acid-based complexing agent, a polyacrylic acid-based complexing agent, and a polybutenoic acid-based complexing agent; and
annealing the perovskite light absorption layer precursor to obtain a perovskite light absorption layer.

**17.** The method for preparing a perovskite solar cell according to claim 16, wherein a first carrier transport layer is arranged between the first electrode layer and the perovskite light absorption layer, and the method for preparing the perovskite solar cell comprises:

providing an intermediate member comprising a substrate, a first electrode layer, and a first carrier transport layer;
forming a perovskite light absorption layer precursor on the first carrier transport layer, wherein during the formation of the perovskite light absorption layer precursor, a complexing agent is added, and the complexing agent comprises one or more of a hydroxycarboxylic acid-based complexing agent, an organic phosphonic acid-based complexing agent, a polyacrylic acid-based complexing agent, and a polybutenoic acid-based complexing agent; and
annealing the perovskite light absorption layer precursor to obtain a perovskite light absorption layer.

**18.** The method for preparing a perovskite solar cell according to claim 17, wherein the formation of the perovskite light absorption layer precursor on the first carrier transport layer comprises:
applying a perovskite precursor solution containing a complexing agent to the first carrier transport layer to form a perovskite composite layer.

**19.** The method for preparing a perovskite solar cell according to claim 17 or 18, wherein the formation of the perovskite

light absorption layer precursor on the first carrier transport layer comprises:
applying a perovskite precursor solution containing a complexing agent to the first carrier transport layer, wherein the concentration of the complexing agent in the perovskite precursor solution containing the complexing agent is less than or equal to 10% of the concentration of a cation in position B in the perovskite precursor.

**20.** The method for preparing a perovskite solar cell according to claim 19, wherein the formation of the perovskite light absorption layer precursor on the first carrier transport layer comprises:

forming a perovskite layer on the first carrier transport layer; and
applying a complexing agent solution to a surface of the perovskite layer away from the first carrier transport layer.

**21.** The method for preparing a perovskite solar cell according to claim 20, wherein a concentration of the complexing agent solution is greater than 0 and less than or equal to 20 mg/ml.

**22.** The method for preparing a perovskite solar cell according to claim 20 or 21, wherein the formation of the perovskite light absorption layer precursor on the first carrier transport layer comprises:

applying a perovskite precursor solution containing a complexing agent to the first carrier transport layer to form a perovskite composite layer, wherein the concentration of the complexing agent in the perovskite precursor solution containing the complexing agent is less than or equal to 10% of the concentration of a cation in position B in the perovskite precursor; and
applying a complexing agent solution to a surface of the perovskite composite layer away from the first carrier transport layer.

**23.** A photovoltaic module, comprising the perovskite solar cell according to any one of claims 1-15 or a perovskite solar cell prepared by the method for preparing a perovskite solar cell according to any one of claims 16-22.

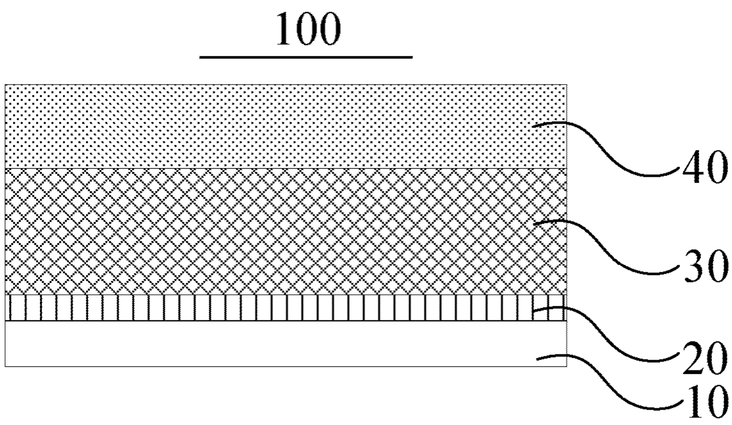


FIG. 1

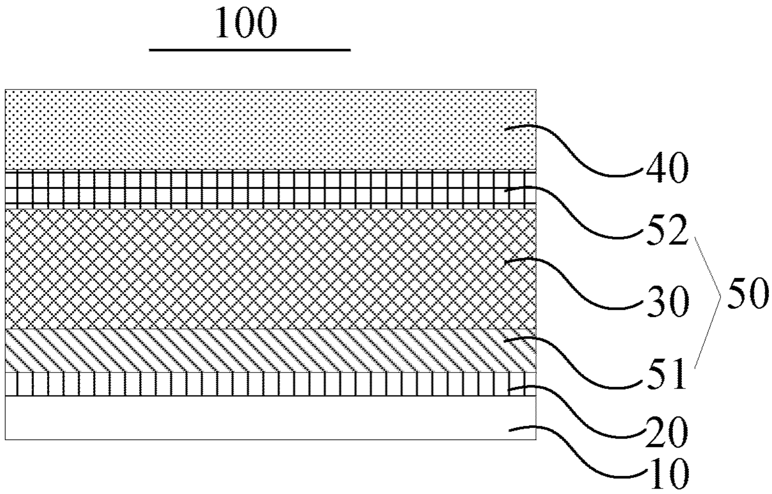


FIG. 2

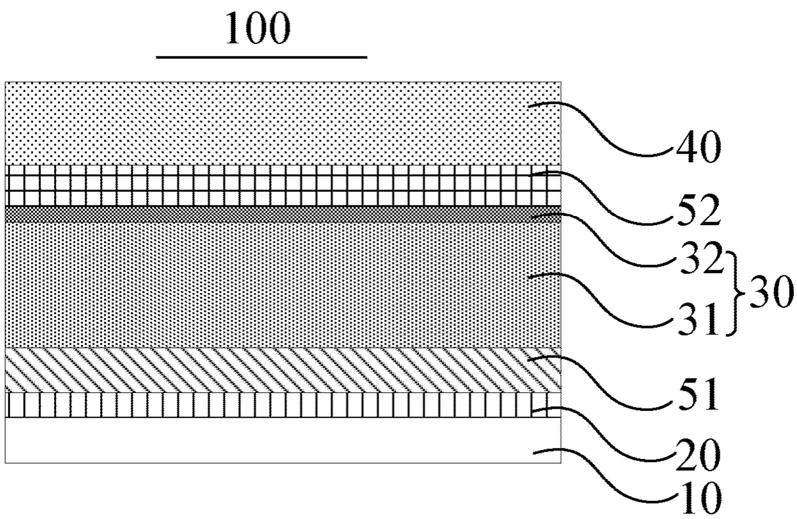


FIG. 3

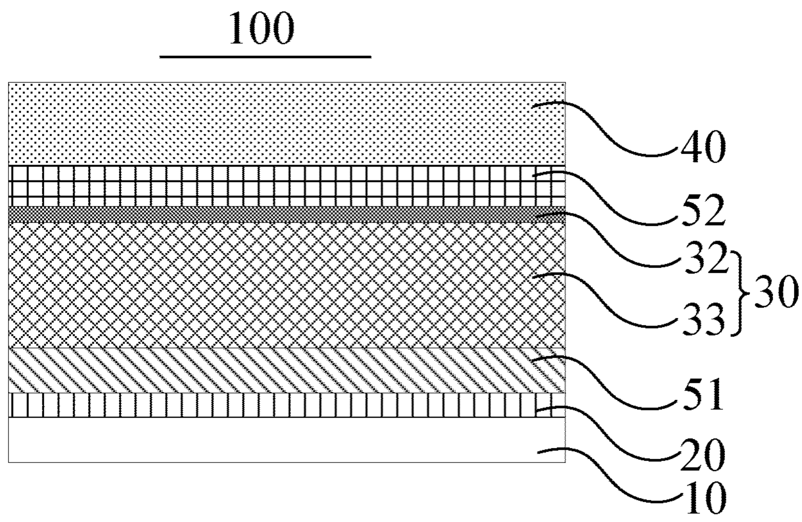


FIG. 4

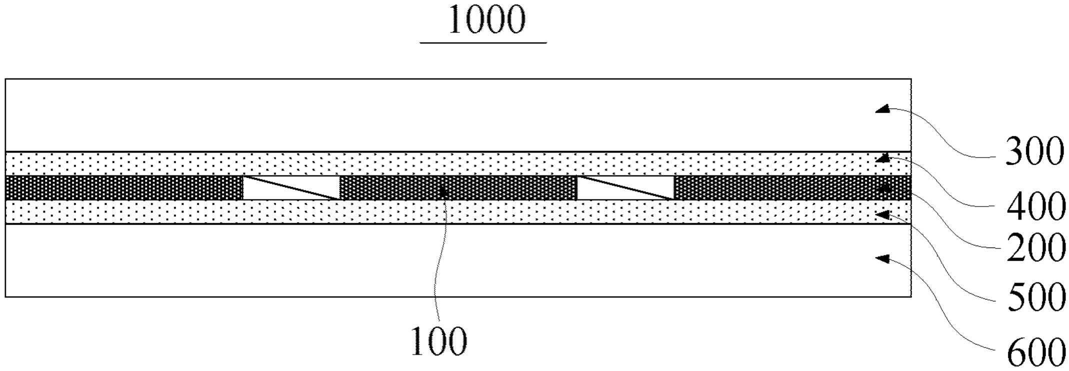


FIG. 5

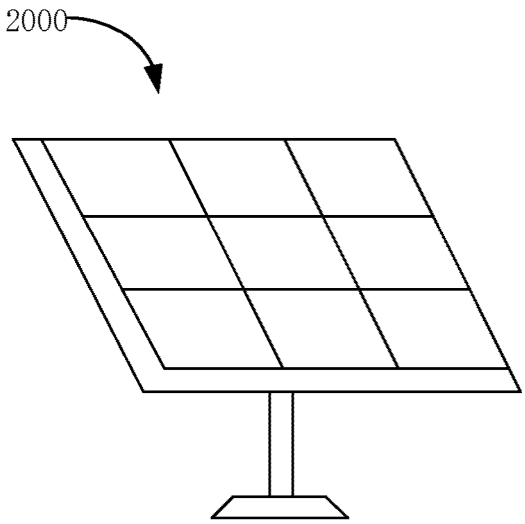


FIG. 6

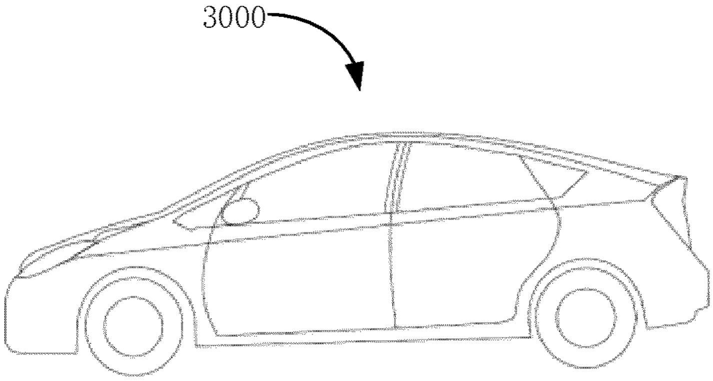


FIG. 7

**INTERNATIONAL SEARCH REPORT**

International application No. **PCT/CN2024/092392**

**A. CLASSIFICATION OF SUBJECT MATTER**

H10K 30/20(2023.01)i; H10K 71/12(2023.01)i; H10K 71/15(2023.01)i; H10K 71/40(2023.01)i

According to International Patent Classification (IPC) or to both national classification and IPC

**B. FIELDS SEARCHED**

Minimum documentation searched (classification system followed by classification symbols)

IPC: H10K

Documentation searched other than minimum documentation to the extent that such documents are included in the fields searched

Electronic data base consulted during the international search (name of data base and, where practicable, search terms used)

CNTXT; CNABS; CNKI; VEN; USTXT; EPTXT; WOTXT: 钙钛矿, 钝化, 酒石酸, 海藻酸, 葡萄糖酸, 庚糖酸, 膦酸, 胺, 氨, 聚丙烯酸, 聚丙烯酰胺, 聚马来酸酐, 聚羟基丙烯酸, 羟基, Perovskite, passivat+, tartaric acid, alginic acid, gluconic acid, heptanonic acid, phosphonic acid, amine, ammonia, polyacrylic acid, polyacrylamide, polymaleic anhydride, polyhydroxyacrylic acid, hydroxyl

**C. DOCUMENTS CONSIDERED TO BE RELEVANT**

| Category* | Citation of document, with indication, where appropriate, of the relevant passages | Relevant to claim No. |
|---|---|---|
| X | CN 110808335 A (JILIN NORMAL UNIVERSITY) 18 February 2020 (2020-02-18) description, paragraphs [0002]-[0039], and figures 1-5 | 1-4, 9-23 |
| X | CN 107123736 A (GUANGZHOU GUANGDING TECHNOLOGY CO., LTD.) 01 September 2017 (2017-09-01) description, paragraphs [0002]-[0142] | 1, 5-7, 9-23 |
| X | CN 113462111 A (ZHEJIANG UNIVERSITY) 01 October 2021 (2021-10-01) description, paragraphs [0002]-[0087], and figures 1-5 | 1, 8-23 |
| X | CN 113980669 A (ZHEJIANG UNIVERSITY et al.) 28 January 2022 (2022-01-28) description, paragraphs [0002]-[0046], and figures 1-4 | 1, 8-23 |
| A | CN 110492000 A (UNIVERSITY OF ELECTRONIC SCIENCE AND TECHNOLOGY OF CHINA) 22 November 2019 (2019-11-22) entire document | 1-23 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **04 June 2024** | **25 June 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**

International application No.
**PCT/CN2024/092392**

**C. DOCUMENTS CONSIDERED TO BE RELEVANT**

| Category* | Citation of document, with indication, where appropriate, of the relevant passages | Relevant to claim No. |
|---|---|---|
| A | CN 112086564 A (HANGZHOU MICROQUANTA CO., LTD.) 15 December 2020 (2020-12-15)<br>entire document | 1-23 |
| A | CN 112635679 A (QINGDAO INSTITUTE OF BIOENERGY AND BIOPROCESS TECHNOLOGY, CHINESE ACADEMY OF SCIENCES) 09 April 2021 (2021-04-09)<br>entire document | 1-23 |
| A | CN 113571649 A (NANKAI UNIVERSITY) 29 October 2021 (2021-10-29)<br>entire document | 1-23 |

Form PCT/ISA/210 (second sheet) (July 2022)

**INTERNATIONAL SEARCH REPORT**
**Information on patent family members**

International application No.
**PCT/CN2024/092392**

| Patent document cited in search report | | | Publication date (day/month/year) | Patent family member(s) | | | Publication date (day/month/year) |
|---|---|---|---|---|---|---|---|
| CN | 110808335 | A | 18 February 2020 | CN | 110808335 | B | 15 November 2022 |
| CN | 107123736 | A | 01 September 2017 | CN | 107123736 | B | 17 May 2019 |
| CN | 113462111 | A | 01 October 2021 | CN | 113462111 | B | 26 April 2022 |
| CN | 113980669 | A | 28 January 2022 | | None | | |
| CN | 110492000 | A | 22 November 2019 | CN | 110492000 | B | 20 November 2020 |
| CN | 112086564 | A | 15 December 2020 | WO | 2020248864 | A1 | 17 December 2020 |
| CN | 112635679 | A | 09 April 2021 | CN | 112635679 | B | 03 February 2023 |
| CN | 113571649 | A | 29 October 2021 | CN | 113571649 | B | 17 November 2023 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 2023106645292